# FASCICULE DE BREVET EUROPEEN

(11) **EP 1 993 129 B1**
(45) Date de publication et mention de la délivrance du brevet: **27.03.2013**
(21) Numéro de dépôt: 08354029.4
(22) Date de dépôt: 15.05.2008
(51) Int. Cl.: H01L 21/768

(54) **Procédé de frabrication de cavités d'air utilisant des nanotubes**
Herstellungsverfahren von Lufthohlräumen mit Hilfe von Nanokanälen
Method for manufacturing air cavities using nanotubes

(30) Priorité: 15.05.2007 FR 0703487
(43) Date de publication de la demande: 19.11.2008
(73) Titulaire: Commissariat à l'Énergie Atomique et aux Énergies Alternatives, 75015 Paris (FR)
(72) Inventeur: Gaillard, Frédéric-Xavier, 38500 Voiron (FR); Coiffic, Jean-Christophe, 38000 Grenoble (FR)
(74) Mandataire: Hecké, Gérard

(56) Documents cités:
- US-A1- 2005 124 172

## Description

### Domaine technique de l'invention

L'invention est relative à un procédé de fabrication de cavités d'air dans une couche cible comportant successivement :
- la réalisation de la couche cible, comportant au moins un matériau dégradable,
- le dépôt d'une couche d'isolation au-dessus de la couche cible
- et la dégradation sélective de zones prédéterminées de la couche cible à travers la couche d'isolation, lesdites zones formant lesdites cavités d'air.

### État de la technique

De nos jours, les circuits électroniques intégrés présentent une proportion non négligeable d'éléments métalliques. Ces derniers peuvent être utilisés en tant qu'éléments d'interconnexions, antennes, bobines ou inductances. Avec la réduction des distances séparant les couches métalliques, les couplages électrostatiques ou électromagnétiques augmentent entre ces éléments, ce qui à pour effet de modifier leur comportement électrique. D'une manière générale, ces couplages électrostatiques sont modélisés par l'apparition d'au moins une capacité parasite entre les éléments métalliques. La réduction du couplage passe par une diminution de la permittivité diélectrique du matériau se trouvant entre lesdits éléments métalliques.

Pour les générations actuelles de circuits intégrés, l'utilisation de matériaux diélectriques à faible permittivité (de l'ordre de 2,3 à 2,7) est compatible avec les performances visées. Ces diélectriques à faible permittivité remplacent avantageusement les oxydes de silicium. Cependant, pour les générations technologiques à venir (noeuds inférieurs à 32nm), les besoins en performance sont nettement supérieurs à la faible amélioration de la permittivité actuellement mesurée sur les matériaux massifs déposés. L'utilisation de cavités d'air (« Air Gap » en anglais) dans les structures d'interconnexions semble aujourd'hui inévitable. Avec de telles architectures, les cavités d'air présentes entre les lignes de conducteurs apportent des permittivités égales à 1.

Actuellement, une voie possible pour la fabrication de ces cavités est l'utilisation d'un dépôt non-conforme de diélectrique sur des couches d'interlignes de matériau métallique. Cette approche, décrite par Gosset et al. (« General review of issues and perspectives for advanced copper interconnections using air gap as ultra-low K material », Proceeding of the IEEE, 2003, International Interconnect Technology Conference (2003) 65), permet d'obtenir, sous certaines conditions de fabrication et avec un surplus d'étapes technologiques complexes et coûteuses, les cavités recherchées.

Une autre solution envisagée consiste à intégrer un matériau sacrificiel entre les motifs en matériau métallique, formant ainsi le niveau intermétallique. Ce matériau réagit après son intégration au moyen de divers procédés physico-chimiques (recuit thermique, traitement par rayonnement UV (« Benefits and Trade-offs in Multi-Level Air Gap Integration », Spring MRS San Diego, avril 2006), ou attaque chimique (brevet US7172980). De cette manière, il est possible de réaliser en totalité ou en partie, l'intégration des niveaux d'interconnexions avec le matériau sacrificiel, puis de former les cavités d'air. Cependant, cette approche limite fortement l'étendue des matériaux utilisables lors de l'intégration. Le matériau sacrificiel qui doit laisser place à la cavité doit en effet être compatible avec la technologie des semiconducteurs, être dégradable et, tout comme son retrait, les procédés physico-chimiques utilisés ne doivent pas détériorer les dispositifs électroniques déjà intégrés (transistors CMOS, capacités...). De même, les matériaux jouxtant le matériau sacrificiel doivent présenter une tenue à ces procédés physico-chimiques, afin de ne pas s'altérer, mais certains de ces matériaux doivent permettre la dégradation et le retrait du matériau sacrificiel en étant, par exemple, perméables aux multiples processus chimiques.

US 2005/0124172 décrit la fabrication de cavités d'air comportant le dépôt d'une couche d'isolation, comprenant par exemple des nanotubes, au dessus d'une couche cible.

### Objet de l'invention

L'objet de l'invention consiste à réaliser un enchaînement d'étapes technologiques visant à pallier les inconvénients précités. Plus particulièrement, l'invention a pour but un procédé de fabrication moins complexe et moins coûteux.

Selon l'invention, ce but est atteint par le fait que le procédé comporte, avant le dépôt de la couche d'isolation, la formation de nanotubes sur la couche cible, une majorité de nanotubes traversant la couche d'isolation et constituant des passages entre la couche cible et l'extérieur.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- Les figures 1 à 5 représentent les étapes successives d'un premier mode de réalisation particulier du procédé selon l'invention.
- Les figures 6 à 9 représentent les étapes successives d'un deuxième mode de réalisation du procédé selon l'invention.
- Les figures 10 à 12 représentent diverses étapes d'un troisième mode de réalisation du procédé selon l'invention.

### Description d'un mode préférentiel de l'invention

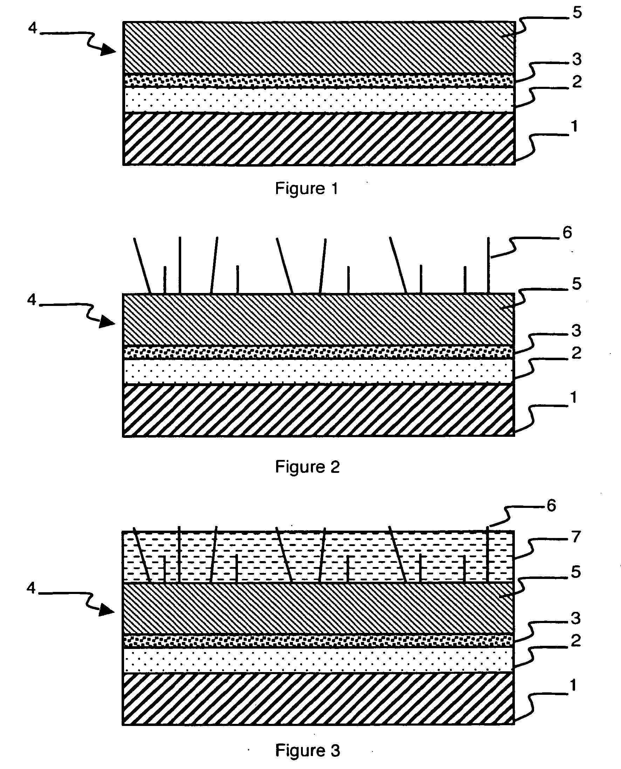

Dans le premier mode particulier de réalisation, comme illustré sur la figure 1, une couche cible 4 est réalisée sur un substrat 1, qui peut comporter de multiples couches 1, 2 et 3. Dans ce mode particulier de réalisation, la couche cible 4 est uniquement composée d'un matériau dégradable 5. Le matériau dégradable 5 est, par exemple, de la silice (SiO₂) qui peut être dégradé par attaque chimique ou un polymère thermiquement dégradable, tel que du polyméthylméthacrylate ou de l'alpha-terpinène.

Comme illustré sur la figure 2, des nanotubes 6 sont formés sur la couche cible 4, par tout procédé connu, par exemple par voie catalytique, par décharge électrique à haute température ou par ablation laser. Les nanotubes 6 présentent alors une extrémité en contact avec le matériau sacrificiel 5. Les nanotubes 6 sont, par exemple, des nanotubes de carbone ou des nanotubes d'oxyde titane et sont, préférentiellement de forme cylindrique creuse. Les nanotubes 6 ne sont pas forcément strictement verticaux et peuvent également être tordus. La majorité des nanotubes 6 est sensiblement perpendiculaire à la surface de la couche cible 4 sur laquelle ils sont formés.

Comme illustré sur la figure 3, une couche d'isolation 7 est ensuite déposée sur la couche cible 4 et les nanotubes 6. Selon les conditions de dépôt de la couche d'isolation 7, les nanotubes 6 peuvent alors présenter ou non une extrémité libre, c'est-à-dire une extrémité non enrobée par la couche d'isolation 7. Dans le cas où la majorité des nanotubes 6 ne traverse pas, de part en part, la couche d'isolation 7, une étape supplémentaire (non représentée) est nécessaire pour libérer une extrémité libre de nanotubes 6. La majorité des nanotubes traverse alors la couche d'isolation et constitue des passages entre la couche cible 4 et l'extérieur. Cette étape supplémentaire est réalisée par tout moyen connu et peut être, par exemple, constituée par un polissage mécano-chimique, une gravure par plasma ou une gravure par voie humide qui élimine spécifiquement la couche d'isolation 7. La couche d'isolation 7 est, préférentiellement, suffisamment rigide (suffisamment dense et avec un module d'young approprié) pour ne pas se déformer, ou peu se déformer, une fois que les cavités d'air sont formées dans la couche cible 4. De même, la couche d'isolation 7 est choisie de façon à ne pas être attaquée lors du processus de dégradation du matériau dégradable 5. La couche 7 est, préférentiellement, imperméable à l'agent d'attaque chimique utilisée pour dégrader le matériau 5 ainsi qu'aux sous-produits de dégradation. Avantageusement, la couche supérieure 3 du substrat 1, également en contact avec le matériau dégradable 5, présente les mêmes caractéristiques que la couche d'isolation 7.

L'ensemble ainsi formé est soumis à des agents 10 de dégradation du matériau dégradable 5. Cette dégradation peut être, par exemple, réalisée par tout procédé connu, par exemple par un procédé thermique, par rayonnement (par exemple rayonnement ultraviolet) ou par tout phénomène ondulatoire approprié ou par attaque chimique par un agent sous forme liquide ou gazeux.

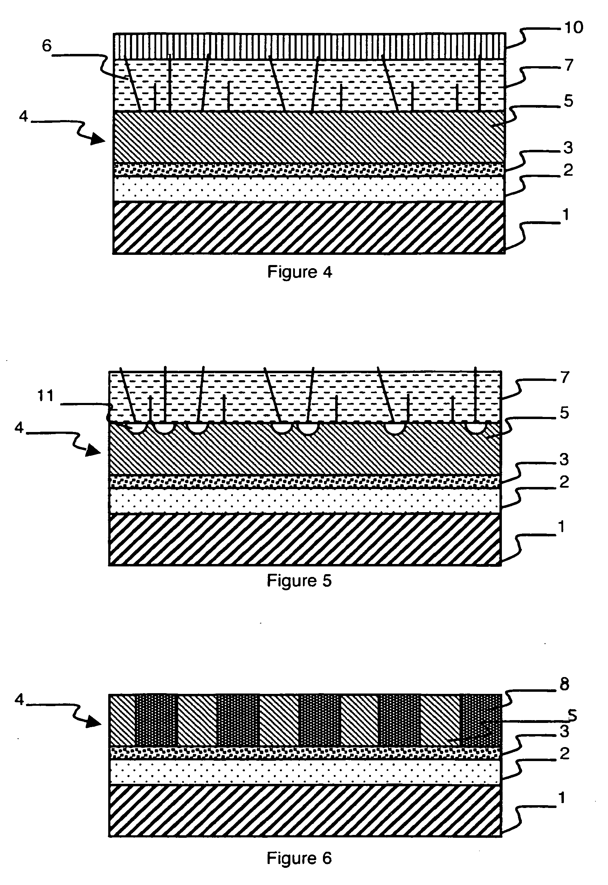

Comme illustré sur la figure 4, dans le cas d'une attaque chimique par un agent 10 sous forme liquide, l'agent 10 peut, par exemple, être disposé sous forme d'une solution sur la couche d'isolation 7. L'agent 10 peut alors, à travers les nanotubes 6 traversant la couche d'isolation 7, dégrader le matériau sacrificiel 5, les nanotubes constituent ainsi des passages pour le liquide ou le gaz entre la couche cible et l'extérieur. La formation de nanotubes destinés à servir de passage à un gaz ou à un liquide dans le domaine de la biologie a notamment été décrit dans l'article « Enhanced flow in carbone nanotubes » Nature, 438 (2005) 44. Les caractéristiques des nanotubes 6, en particulier leur diamètre, sont définies, dans le cas d'une attaque chimique, de manière à autoriser leur traversée par un agent 10 capable de dégrader le matériau dégradable 5. Si l'on utilise un procédé de dégradation thermique ou ondulatoire du matériau dégradable 5, les nanotubes 6 ne sont pas utilisés par l'agent de dégradation. Cependant, dans tous les cas, les caractéristiques des nanotubes 6 doivent être choisies de façon à permettre aux sous-produits de la dégradation du matériau dégradable 5 d'être éliminés vers l'extérieur par l'intermédiaire des nanotubes. Lorsque les nanotubes 6 sont des nanotubes de carbone, la diffusion de l'agent de dégradation et/ou des sous-produits de dégradations par l'intermédiaire des nanotubes s'effectue soit entre les plans de graphène, soit à l'interface nanotube-couche d'isolation, soit dans le canal creux du nanotube 6. Les nanotubes 6 peuvent également être par exemple des nanotubes d'oxyde de titane, de nitrure de gallium, à base de composés de terres rares.

Avantageusement, si l'on souhaite obtenir des nanotubes 6, réalisés par voie catalytique, complètement creux, les grains de catalyseurs utilisés pour leur formations peuvent être éliminés, par exemple, au moyen d'une solution d'acide (par exemple d'acide nitrique HNO₃).

Par ailleurs, les nanotubes 6 peuvent être également partiellement dégradés avant ou pendant la dégradation du matériau dégradable 5, de manière à agrandir le passage constitué par les nanotubes 6. Il est également possible d'éliminer totalement les nanotubes 6 avant de procéder à la dégradation du matériau 5, les passages étant alors constitués par les trous présents dans la couche d'isolation 7. Les nanotubes 6 peuvent alors être éliminés, par exemple, par plasma ou par solution chimique en fonction de leur nature. Par exemple, pour des nanotubes de carbones, on utilisera un plasma à base d'oxygène.

La formation, de passages, constitués par les nanotubes ou les trous correspondants, entre la couche cible 4 et l'extérieur, au sein de la couche d'isolation 7, permet ainsi à un agent 10, chimique, d'atteindre et de dégrader le matériau dégradable 5 et, après dégradation du matériau 5, aux résidus de dégradation d'être éliminés à travers la couche d'isolation 7 pour créer des cavités d'air 10, au pied de chaque nanotube traversant, comme illustré à la figure 5.

Dans le cas où le matériau dégradable 5 est constitué par de l'oxyde de silicium, sa dégradation peut être réalisée par de l'acide fluorhydrique. Le matériau des couche 3 et 7 est alors choisi de façon à ne pas réagir avec l'acide fluorhydrique, et les couches 3 et 7 sont alors, par exemple, en nitrure de silicium, en carbure de silicium. La couche 7 peut être par exemple en BD1® commercialisée par la société Applied Materials.

Dans un second mode de réalisation, illustré à la figure 6, des motifs (par exemple des plots de contact ou des lignes) réalisés par une alternance de motifs en matériau prédéterminé 8 et en matériau dégradable 5 sont intégrés à l'intérieur de la couche cible 4 et sur toute sa hauteur.

A titre d'exemple, pour intégrer des cavités d'air dans une structure d'interconnexion métallique, la couche cible 4 est formée par une alternance de motifs en matériau dégradable 5 (par exemple de l'oxyde de silicium) et en un matériau prédéterminé 8, par exemple métallique (par exemple du cuivre). Cette alternance est réalisée de façon connue, par exemple, par la méthode damascène. La couche 2 peut alors comporter un ensemble de dispositifs électroniques actifs, par exemple des transistors CMOS, disposés sur un substrat de silicium 1. Sur cette couche 2, peut être disposée une couche 3 d'encapsulation et de planarisation.

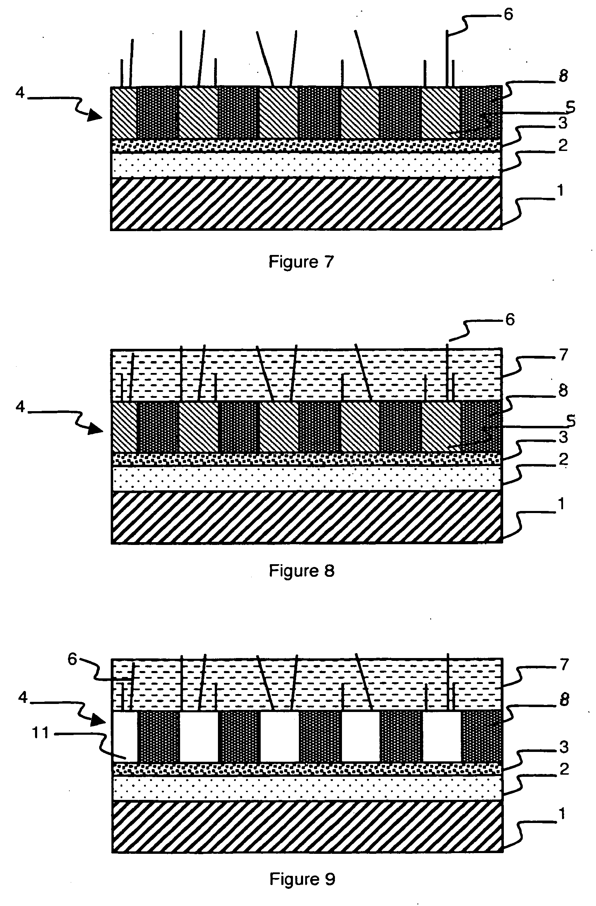

Comme illustré sur la figure 7, des nanotubes 6 sont alors réalisés sur la couche cible 4. Les nanotubes 6 présentent une longueur, préférentiellement, comprise entre 50 et 300nm. Le procédé de dépôt des nanotubes 6 est choisi de façon à ce que les nanotubes 6 soient déposés préférentiellement sur le matériau dégradable 5 et non sur le matériau 8. Dans cette configuration, les nanotubes 6, par exemple, de carbone, sont réalisés préférentiellement par voie catalytique. Le choix entre un procédé de dépôt chimique en phase vapeur (« Chemical Vapor Déposition ») et un procédé de dépôt chimique en phase vapeur assisté par plasma (« Plasma Enhanced Chemical Vapor Deposition ») est effectué en fonction des caractéristiques recherchées pour les nanotubes 6.

Le diamètre des nanotubes 6 est choisi en fonction de l'application recherchée ainsi qu'en fonction du procédé de dégradation et des sous-produits en découlant, typiquement entre 1 nm et 300nm. En effet, plus le nanotube 6 est large et plus la diffusion des espèces chimiques (agent 10) est aisée. De même, les sous-produits de dégradation sont susceptibles d'être évacués beaucoup plus rapidement si le nanotube 6 est large.

Si une attaque très localisée est recherchée, l'utilisation de nanotubes 6 fins sera favorisée, ainsi que des procédés de dégradations adaptés (temps relativement court d'attaque chimique ou de recuit). Si, au contraire, de larges cavités sont recherchées sous les nanotubes 6, alors des nanotubes 6 larges seront réalisés, éventuellement avec un agent 10 de dégradation chimique très concentré, ou un temps d'attaque plus long sera utilisé. L'homme du métier adaptera le temps de gravure à la concentration de la solution d'attaque chimique.

La densité de nanotubes 6 est également choisie selon l'application recherchée, la densité de nanotubes 6 est préférentiellement comprise entre 0,3 nanotube/nm² et 10⁻⁴ nanotube/nm². Si la densité de nanotubes est trop importante, la couche d'isolation 7 n'enrobe pas chaque nanotube individuellement, dans ce cas la solution d'attaque diffuse entre les nanotubes 6.

Comme illustré sur la figure 8, la couche d'isolation 7 est déposée, au moins, sur la couche cible 4 et sur les nanotubes 6. Cette couche d'isolation 7 est préférentiellement en matériau diélectrique et avantageusement un matériau diélectrique à faible constante diélectrique (de l'ordre de 2 à 5). Cette couche d'isolation 7 a une épaisseur typiquement dans la gamme 20-500nm.

Avantageusement, la couche d'isolation 7 est de type Méthylsilsesquioxane et plus particulièrement en matériau BD1® commercialisée par la société Applied Materials. Si la couche d'isolation 7 enrobe complètement les nanotubes 6, une étape supplémentaire peut être mise en oeuvre pour libérer une extrémité des nanotubes 6.

Une fois cette architecture obtenue, la dégradation du matériau dégradable 5 est réalisée comme précédemment. La dégradation et l'élimination du matériau 5 est de préférence totale. Comme illustré sur la figure 9, les cavités d'air 11 ainsi formées au sein de la couche cible 4, remplacent alors totalement le matériau dégradable 5, qui constitue ainsi un matériau sacrificiel. Les cavités d'air 11 sont alors déterminées par les motifs préalablement formés dans la couche 4 et délimitées par les zones initialement remplies par le matériau 5.

Dans une variante de ce mode de réalisation, le matériau 5 est dégradable thermiquement, les autres matériaux pouvant rester inchangés. Le matériau dégradable 5 est alors, par exemple, de type polymère (par exemple en polyméthylmétacrylate PMMA, de type porogène en Norbornadiène ou alpha-terpinène...). Dans cette approche, la structure est alors chauffée de manière à réaliser la dégradation thermique du matériau dégradable 5. Les sous-produits de dégradations peuvent alors diffuser hors de la couche cible 4 au moyen des nanotubes 6 faisant office de passages.

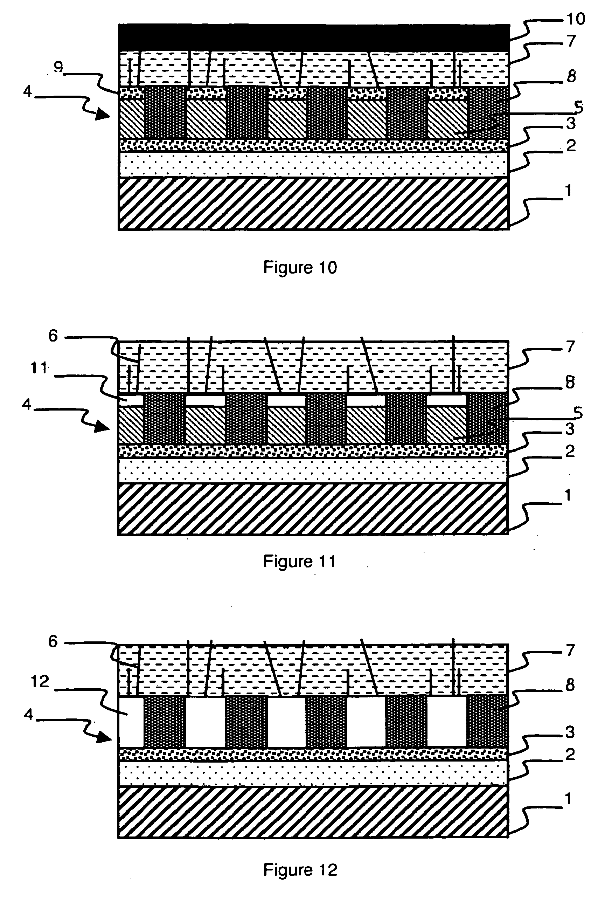

Dans un troisième mode de réalisation, illustré par la figure 10, la couche cible 4 comporte un matériau dégradable additionnel 9 déposé sur le matériau dégradable 5. Ensuite, à l'intérieur de cette couche 4 et sur toute sa hauteur sont intégrés des motifs (par exemple des plots de contact ou des lignes) en matériau prédéterminé 8, préférentiellement métallique, par exemple en cuivre. Cette intégration peut être réalisée par toute technique connue, par exemple par la technique damascène. La couche 4 est alors constituée par une alternance de matériau métallique 8 et de l'empilement du matériau dégradable 5 et du matériau dégradable additionnel 9. Les matériaux 5 et 9 ont des caractéristiques de dégradation différentes.

Le matériau dégradable additionnel 9 est choisi préférentiellement de façon à faciliter le dépôt des nanotubes 6. A titre d'exemple, le matériau dégradable 5 peut être un matériau thermiquement dégradable comme le PMMA, le p-SILK®, le Spin On Glass ou le PhiLK®) particulièrement adapté à l'application recherchée. Le matériau dégradable additionnel 9 est alors, par exemple, un matériau chimiquement dégradable, comme de l'oxyde de silicium qui autorise une plus grande facilité de réalisation de nanotubes 6 que le matériau dégradable 5. Des nanotubes 6 de carbones sont alors formés sur le matériau dégradable additionnel 9.

Comme illustré sur la figure 11, la dégradation du matériau dégradable additionnel 9 et son évacuation sont réalisées après dépôt d'une couche d'isolation 7. Une solution d'acide fluorhydrique est préférentiellement utilisée pour éliminer au moins partiellement les motifs en matériau dégradable additionnel 9 et former des cavités d'air 11 dans les zones initialement remplies par le matériau 9. Ensuite, la dégradation et l'évacuation du matériau dégradable 5 sont réalisées. Une dégradation thermique est préférentiellement utilisée. Le matériau dégradable 5 et le matériau dégradable additionnel 9 ayant tous deux été éliminés, les cavités d'air 12 sont ainsi formées entre les motifs en matériau métallique 8, comme illustré par la figure 12, dans toutes les zones initialement remplies par les matériaux 5 et 9.

La superposition de deux matériaux dégradables ayant des caractéristiques de dégradations différentes peut permettre d'optimiser la vitesse de dégradation et les conditions de formation des nanotubes 6.

## Revendications

1. Procédé de fabrication de cavités d'air (11) dans une couche cible (4) comportant successivement :
- la réalisation de la couche cible (4), comportant au moins un matériau dégradable (5),
- le dépôt d'une couche d'isolation (7) au-dessus de la couche cible (4),
- et la dégradation sélective de zones prédéterminées de la couche cible, (4) à travers la couche d'isolation (7), lesdites zones formant lesdites cavités d'air,
procédé **caractérisé en ce qu'**il comporte, avant le dépôt de la couche d'isolation(7), la formation de nanotubes (6) sur la couche cible (4), une majorité de nanotubes (6) traversant la couche d'isolation (7) et constituant des passages entre la couche cible (4) et l'extérieur.

2. Procédé selon la revendication 1, **caractérisé en ce que** les nanotubes (6) comportant une extrémité en contact avec la couche cible (4), le procédé comporte après dépôt de la couche d'isolation (7), une étape de libération de l'autre extrémité des nanotubes (6).

3. Procédé selon l'une des revendications 1 et 2, **caractérisé en ce que** la dégradation sélective du matériau dégradable (5) est réalisée par attaque chimique, par l'intermédiaire des nanotubes (6), la couche d'isolation (7) étant imperméable audit agent (10) chimique.

4. Procédé selon l'une des revendications 1 et 2, **caractérisé en ce que** la dégradation sélective du matériau dégradable (5) est réalisée par un procédé thermique.

5. Procédé selon l'une des revendications 1 et 2, **caractérisé en ce que** la dégradation sélective du matériau dégradable (5) est réalisée par rayonnement.

6. Procédé selon l'une quelconque des revendications 1 à 5, **caractérisé en ce que** la couche cible (4) présente une alternance de motifs en matériau dégradable (5, 9) et en matériau non dégradable (8).

7. Procédé selon la revendication 6, **caractérisé en ce que** les motifs en matériau dégradable sont constitués par au moins deux matériaux dégradables superposés (5, 9) présentant des caractéristiques de dégradation différentes.

8. Procédé selon l'une des revendications 6 à 7, **caractérisé en ce que** la formation des nanotubes (6) est réalisée essentiellement sur le matériau dégradable (5, 9).

9. Procédé selon l'une quelconque des revendications 1 à 8, **caractérisé en ce que** les nanotubes (6) sont des nanotubes de carbone.

10. Procédé selon l'une quelconque des revendications 1 à 8, **caractérisé en ce que** les nanotubes (6) sont des nanotubes d'oxyde de titane.

## Claims

1. A method for producing air gaps (11) in a target layer (4) successively comprising:
- fabricating the target layer (4) comprising at least one degradable material (5),
- depositing an insulating layer (7) above the target layer (4),
- and selective degradation of predetermined zones of the target layer (4) through the insulating layer (7), said zones forming said air gaps,
a method **characterized in that** it comprises formation of nanotubes (6) on the target layer (4), before depositing the insulating layer (7), a majority of nanotubes (6) passing through the insulating layer (7) and forming passages between the target layer (4) and the outside.

2. The method according to claim 1, **characterized in that** the nanotubes (6) comprise an end in contact with the target layer (4), the method comprising a step of freeing the other end of the nanotubes (6) after the insulating layer (7) has been deposited.

3. The method according to one of claims 1 and 2, **characterized in that** selective degradation of the degradable material (5) is performed by chemical etching by means of the nanotubes (6), the insulating layer (7) being impervious to said chemical agent (10).

4. The method according to one of claims 1 and 2, **characterized in that** selective degradation of the degradable material (5) is performed by a thermal process.

5. The method according to one of claims 1 and 2, **characterized in that** selective degradation of the degradable material (5) is performed by radiation.

6. The method according to any one of claims 1 to 5, **characterized in that** the target layer (4) presents an alternation of patterns made from degradable material (5, 9) and non-degradable material (8).

7. The method according to claim 6, **characterized in that** the patterns made from degradable material are formed by at least two superposed degradable materials (5, 9) presenting different degradation characteristics.

8. The method according to one of claims 6 to 7, **characterized in that** formation of the nanotubes (6) is performed essentially on the degradable material (5, 9).

9. The method according to any one of claims 1 to 8, **characterized in that** the nanotubes (6) are carbon nanotubes.

10. The method according to any one of claims 1 to 8, **characterized in that** the nanotubes (6) are titanium oxide nanotubes.

## Patentansprüche

1. Verfahren zur Herstellung von Lutthohlräurnen (11) in einer Zielschicht (4), das nacheinander umfasst:
das Ausbilden der Zielschicht (4), die wenigstens ein abbaubares Material (5) umfasst,
das Abscheiden einer Isolierschicht (7) oberhalb der Zielschicht (4) und
- das selektive Abbauen von vorbestimmten Bereichen der Zielschicht (4) durch die Isolierschicht (7) hindurch, wobei die Bereiche die Lufthohlräume bilden,
Verfahren, das **dadurch gekennzeichnet ist, dass** es vor dem Abscheiden der Isolierschicht (7) die Bildung von Nanoröhren (6) auf der Zielschicht (4) umfasst, wobei eine Mehrheit von Nanoröhren (6) die Isolierschicht (7) durchzieht und Durchgänge zwischen der Zielschicht (4) und der Außenseite bildet.

2. Verfahren nach Anspruch 1, **dadurch gekennzeichnet, dass** - da die Nanoröhren (6) ein mit der Zielschicht (4) in Kontakt befindliches Ende aufweisen - das Verfahren nach Abscheiden der Isolierschicht (7) einen Schritt zum Freilegen des anderen Endes der Nanoröhren (6) umfasst.

3. Verfahren nach einem der Ansprüche 1 und 2, **dadurch gekennzeichnet, dass** das selektive Abbauen des abbaubaren Materials (5) durch chemisches Ätzen, mittels der Nanoröhren (6) vollzogen wird, wobei die Isolierschicht (7) für das chemische Agens (10) undurchlässig ist.

4. Verfahren nach einem der Ansprüche 1 und 2, **dadurch gekennzeichnet, dass** das selektive Abbauen des abbaubaren Materials (5) durch ein thermisches Verfahren vollzogen wird.

5. Verfahren nach einem der Ansprüche 1 und 2, **dadurch gekennzeichnet, dass** das selektive Abbauen des abbaubaren Materials (5) mittels Strahlung vollzogen wird.

6. Verfahren nach einem der Ansprüche 1 bis 5, **dadurch gekennzeichnet, dass** die Zielschicht (4) einen Wechsel von Mustern aus abbaubarem Material (5, 9) und aus nicht abbaubarem Material (8) aufweist.

7. Verfahren nach Anspruch 6, **dadurch gekennzeichnet, dass** die Muster aus abbaubarem Material durch wenigstens zwei übereinander liegende abbaubare Materialien (5, 9), die unterschiedliche Abbaueigenschaften aufweisen, gebildet sind.

8. Verfahren nach einem der Ansprüche 6 bis 7, **dadurch gekennzeichnet, dass** die Bildung der Nanoröhren (6) im Wesentlichen auf dem abbaubaren Material (5, 9) vollzogen wird.

9. Verfahren nach einem der Ansprüche 1 bis 8, **dadurch gekennzeichnet, dass** die Nanoröhren (6) Kohlenstoffnanoröhren sind.

10. Verfahren nach einem der Ansprüche 1 bis 8, **dadurch gekennzeichnet, dass** die Nanoröhren (6) Titanoxid-Nanoröhren sind.
